# EUROPÄISCHE PATENTSCHRIFT

(11) **EP 1 198 692 B1**
(45) Veröffentlichungstag und Bekanntmachung des Hinweises auf die Patenterteilung: **10.09.2003**
(21) Anmeldenummer: 00951264.1
(22) Anmeldetag: 12.07.2000
(51) Int. Cl.: F28F 13/00, F28F 21/08, H01L 23/373

(54) **WÄRMETAUSCHER**
HEAT EXCHANGER
ECHANGEUR DE CHALEUR

(30) Priorität: 22.07.1999 DE 19934554
(43) Veröffentlichungstag der Anmeldung: 24.04.2002
(73) Patentinhaber: Stollenwerk, Michael, 41462 Neuss (DE)
(72) Erfinder: Stollenwerk, Michael, 41462 Neuss (DE)
(74) Vertreter: Springorum, Harald, Dr.
(86) Internationale Anmeldenummer: DE0002328
(87) Internationale Veröffentlichungsnummer: WO01007858

(56) Entgegenhaltungen:
- EP-A- 0 365 275
- WO-A-99/09594
- FR-A- 1 282 095
- US-A- 4 222 434
- US-A- 4 960 612
- US-A- 5 133 403

## Beschreibung

Die vorliegende Erfindung betrifft Wärmetauscher, sowie Verfahren zu deren Herstellung.

Bekannt sind Wärmetauscher etwa als Kühlkörper in Form von Rippenprofilen, welche vorzugsweise aus Aluminium hergestellt sind. Deren Kühlleistung ist jedoch durch das maximal erzielbare Verhältnis von Kühlkörperoberfläche zu Kühlkörpervolumen begrenzt.

Weiterhin sind etwa aus der EP 0 559 092 Wärmetauscher aus porösem Metallschaum bekannt, die dieses Manko zu beheben suchen. Sie erreichen dabei zwar ein besseres Verhältnis von Kühlkörperoberfläche zu Kühlkörpervolumen, dies jedoch um den Preis einer schlechteren Wärmeleitung bei größeren Poren. Wählt man die Poren jedoch kleiner, so vergrößert sich der Strömungswiderstand des anströmenden Kühlmediums zu stark.

Ähnliche Nachteile weisen Sinterblöcke, wie sie aus der deutschen Gebrauchsmusterschrift G 91 02 117 bekannt sind, auf. Auch hier läßt sich eine gute Wärmeleitfähigkeit nur durch eine genügend feine Körnung des Sintermaterials erreichen, was wiederum zu einem unerwünscht hohen Strömungswiderstand des Wärmetauschers führt.

Daher sind diese Lösungen nur bei Verwendung eines flüssigen Kühlmediums praktikabel, welches auch noch bei gröberen Poren der Kühlkörper eine ausreichende Wärmeabfuhr gewährleistet. Flüssigkühlung bedingt jedoch einen nicht unerheblichen Aufwand für die Heranführung und Ableitung der Kühlflüssigkeit und deren Reinigung oder Vorhaltung in einem Zwischenkreislauf. Ihr Einsatz wird daher in der Regel aufgrund der hiermit verbundenen Kosten auf die Fälle beschränkt, in denen dies unumgänglich ist.

Die WO 99/09594 versucht nun diesen Nachteilen durch eine bestimmte geometrische Ausgestaltung beizukommen, indem sie einen gesinterten Kühlkörper vorschlägt, der einen mäanderförmigen Aufbau des Sinterkörpers aufweist und hierdurch die An- und Abströmflächen des Kühlmediums zum Sinterkörper hin und von diesem weg vergrößert, was den Strömungswiderstand des Wärmetauschers verringert und ihn auf diese Weise auch für gasförmige Kühlmedien nutzbar macht.

Der Gegenstand der WO 99/09594 weist jedoch einen entscheidenden Nachteil auf. Die Mäanderform des eigentlichen Sinterkörpers führt sowohl auf der Anströmseite, wie auf der Abströmseite des Kühlmediums zu nebeneinander liegenden, nur durch den Sinterkörper selbst getrennten Kanälen. Dabei führen die solchermaßen auf der Anströmseite des Kühlmediums liegenden Kanäle zu einem unerwünschten Effekt. Diese Kanäle werden nicht nur an ihren Seiten zu den Abströmkanälen hin durch eine Sinterkörperwand begrenzt, sondern auch an ihrem jeweiligen Ende durch ein Stück Sinterkörper von der Abströmseite des Wärmetauschers getrennt. Somit bilden diese Anströmkanäle eine Art Düse, in der das anströmende Medium zunächst bis zum Ende des Kanals gelangt und dort versucht, durch die den Kanal abschließende Wand aus gesintertem Material zu treten. Erst wenn dort der Strömungswiderstand zu hoch wird, tritt Kühlmedium auch durch die Seitenwände des Kanals hindurch, und zwar zunächst durch die dem Kanalabschlußstück nächst gelegenen Seitenstücke und dann mit steigendem Druck durch die von diesem immer entfernter gelegenen Teile.

Dies ist höchst unbefriedigend, da der Wärmetauscher nach der WO 99/09594 so zwar insgesamt gesehen ein günstiges Verhältnis von Kühlkörperoberfläche zu Kühlkörpervolumen zur Verfügung stellt, jedoch ein anströmendes Kühlmedium diese zur Wärmeabgabe zur Verfügung gestellte Gesamtoberfläche gar nicht nutzen kann, da es nur zu einem geringen Teil zu dieser Gesamtoberfläche in Kontakt tritt. Vielmehr erhält das kleine Sinterkörper-Abschlußstück des Anströmkanals den größten Anteil des anströmenden Kühlmediums, an den es aufgrund der geringen Kontaktfläche in seinem Bereich gar nicht soviel Wärme abgeben kann, wie dieses aufnehmen könnte. Hingegen erhalten die Sinterkörperseitenwände des Abströmkanals nur eine unzureichende Versorgung mit dem Kühlmedium und können daher ihrerseits die hier zur Wärmeabgabe zur Verfügung stehende Oberfläche nicht ausnutzen.

Dieser Nachteil schränkt die Brauchbarkeit des Wärmetauschers nach der WO 99/09594 somit insbesondere bei niedrigeren Anströmgeschwindigkeiten des verwendeten Kühlmediums erheblich ein.

Aus der DE AS 1 639 436 ist ferner eine Lösung bekannt, die die Wärmeleitfähigkeit von Sinterkörpern zu verbessern sucht, indem sie einen Sinterkörper zeigt, der aus einem verpreßten Metallgemisch mit besser und schlechter wärmeleitfähigen Metallen besteht. Hier wird die Verbesserung der Wärmeleitfähigkeit jedoch um den Preis der Verminderung der Kühloberfläche erkauft, da der Sinterkörper verpreßt wird und so die Porosität wieder stark vermindert oder sogar beseitigt wird, was damit selbstverständlich auch die Oberfläche des Körpers verkleinert.

Die Beseitigung der Porosität ist jedoch auch aus anderen Gründen nachteilig. Die poröse Struktur führt nämlich zu einer turbulenten Strömung des Kühlmediums in dem Kühlkörper, da sie zu einer ausreichenden Geschwindigkeitserhöhung der Strömung führt. Mit zunehmender Geschwindigkeit erfolgt nämlich bei der sogenannten kritischen Reynoldszahl ein Umschlag der zunächst laminaren Strömung in eine turbulente Strömung. Ohne diese Struktur hingegen würde die Strömungsgeschwindigkeit nicht steigen und es verbliebe bei einer laminaren Strömung. In der laminaren Strömung bewegen sich die Teilchen des Kühlmediums auf parallelen Bahnen. Die Stromlinien laufen nebeneinander her. Es erfolgt keine Vermischung längs des Strömungsweges. Bedingt durch die Reibung stellt sich in jeder Strömung ein Geschwindigkeitsprofil ein. An der Wand anliegende Teilchen haften. Mit zunehmendem Abstand von der Wand wird die Geschwindigkeit größer. Das Profil der laminaren Strömung steigt flach an. In der laminaren Rohrströmung ist es parabolisch. Bei der wünschenswerten turbulenten Strömung hingegen führen die Teilchen zusätzliche, der Vorwärtsbewegung überlagerte, ungeordnete und regellose Querbewegungen aus. Sie bewegen sich in der Strömung durcheinander. Das Medium vermischt sich längs des Strömungsweges dauernd. Die Art der Strömung hat somit entscheidenden Einfluß auf den Wärmeübergang durch Konvektion. Bei laminarer Strömung gelangt die Wärme aus dem Stoffstrominneren an die Wand oder umgekehrt allein durch Wärmeleitung in dem Medium. In der turbulenten Strömung ist der Wärmetransport nicht allein auf Leitung angewiesen. Die Mischbewegung der Teilchen ergibt einen materiellen Austausch von Flüssigkeit oder dem Medium quer zur Strömung und damit einen direkten Wärmetransport. Dieser beträgt ein Vielfaches der reinen Wärmeleitung innerhalb des Mediums. Durch reine Wärmeleitung ist nur noch die laminare Randschicht zu überbrücken. Der Wärmeübergang bei turbulenter Strömung ist dadurch ein vielfaches besser als bei der laminaren Strömung. Er wächst mit steigender Strömungsgeschwindigkeit. Durch Maßnahmen ( z.B. Aufrauhung der Oberfläche ), die zur Störung oder zur Verkleinerung der laminaren Randschicht führen, läßt er sich verbessern.

Somit ist die Verdichtung eines Kühlkörpers mit Druck, wie in der vorstehend angeführten Schrift dargelegt, nicht wünschenswert, sondern vielmehr kontraproduktiv, da sie die Porosität des Kühlkörpers beseitigt oder vermindert und damit in Folge auch die Entstehung einer die Wärmeableitung fördernden turbulenten Strömung hindert, wie auch die zur Kühlung zur Verfügung stehende Fläche unerwünschterweise verkleinert.

Damit stellt sich dem Fachmann die Aufgabe, einen Wärmetauscher anzugeben, der bei günstigem Verhältnis von Kühlkörperoberfläche zu Kühlkörpervolumen und möglichst geringem Strömungswiderstand trotzdem eine gute Wärmeleitfähigkeit aufweist.

Diese Aufgabe wird durch einen Wärmetauscher gelöst, der einen Kühlkörper aufweist, der einerseits mit einem zu kühlenden Medium und andererseits mit einem Kühlmedium in Kontakt steht und die Wärme des zu kühlenden Mediums auf das Kühlmedium überträgt, dadurch gekennzeichnet, daß der Kühlkörper mindestens aus zwei Materialien besteht, von denen das eine besser wärmeleitend ist als das andere, und das besser wärmeleitende Material im wesentlichen in Kontakt mit dem zu kühlenden Medium steht und die Wärme von diesem zu dem schlechter wärmeleitenden Material hin ableitet, welches im wesentlichen in Kontakt mit dem Kühlmedium steht, auf das es seinerseits die Wärme überträgt und der Kühlkörper weiterhin gesinterte Teile aufweist, die eine poröse Sinterstruktur bilden, welche von dem Kühlmedium durchströmt werden kann, wobei gesinterte Teile aus dem besser wärmeleitenden Material und dem schlechter wärmeleitenden Material bestehen und die Sintertemperatur des besser wärmeleitenden Materials kleiner oder gleich der Temperatur des schlechter wärmeleitenden Materials ist.

Im weiteren stellt sich das Problem der unerwünschten Schichtbildung (Patina), welche den Wärmeübergang erheblich verschlechtern kann. Dies soll im folgenden anhand eines Beispiels, nämlich der unerwünschten Schichtbildung auf Kupfer näher erläutert werden. Das Problem der Schichtbildung findet sich aber auch in anderen Fällen, wie etwa bei Aluminium, das eine große Affinität zu Sauerstoff aufweist, so daß auch hierfür die nachfolgenden Ausführungen prinzipiell gelten. Unter der Einwirkung von Luftinhaltstoffen und Feuchte entstehen auf blanken Oberflächen wie etwa bei Kupfer Anlaufschichten etwa aus Kupfer-Oxid. Innerhalb weniger Stunden bilden sich diese Schichten, die zunächst nur sehr dünn, etwa 2 bis 4 um und damit noch kaum sichtbar sind. Im Zeitablauf werden diese jedoch immer dicker und können auch Dicken zwischen 50 bis 100 µm und mehr erreichen. Mit wachsender Dicke und Dichte verlangsamt sich dann das Anwachsen der Oxidschicht. Im Falle von Kupfer zeigt sich die Zunahme der Schicht im Farbbild. Ausgehend von hellem Kupfer geht die Farbe bei dicker werdender Schicht zunächst in dunkles Braun über und im Anschluß daran über dunkel Grün bis letztlich hin zu hellem Grün. Im Gegensatz zum sogenannten Grünspan, der durch chemische Reaktion von Kupfer mit Essigsäure entsteht und wasserlöslich ist, ist dieser Prozeß das Ergebnis des Einflußes atmosphärischer Bewitterung. Die hierbei entstehende Schicht wird Patina genannt und ist in ihrer chemischen Zusammensetzung abhängig von den herrschenden atmosphärischen Bedingungen. So kann an verschiedenen geographischen Standorten die Patina im wesentlichen aus basischem Kupfersulfat, basischem Kupferchlorid oder basischem Kupferkarbonat bestehen. Damit kann unter unterschiedlichen Betriebsbedingungen auch eine sehr ungünstige chemische Zusammensetzung der Patina entstehen auf deren Problematik hier jedoch nicht weiter eingegangen werden soll. Die Patina als Deckschicht ist als Schutzschicht für das Kupfer bekannt und dabei in ihrer Schutzwirkung auch unabhängig von der chemischen Zusammensetzung. Die Korrosionsgeschwindigkeit des blanken Kupfers verlangsamt sich durch die Deckschicht erheblich. Die Patina ist selbst sehr stabil und bildet sich bei Beschädigung sofort wieder neu. So positiv und erwünscht die Patinabildung für die Korrosionsbeständigkeit ist, so nachteilig ist sie jedoch für die Ausnutzung anderer physikalischer Eigenschaften, wie etwa der Wärmeleitfähigkeit des Kupfers unter atmosphärischem, wie auch unter Einfluß anderer Medien, die die Schutzschichtbildung nicht unterbinden oder sogar fördern. Daher gilt es bei Wärmetauschern solche Patina zu vermeiden. Nichtsdestotrotz führt eine Kühlung des Wärmetauschers mit Luft zu dem Problem, daß mit Zunahme der Feuchtigkeit eine zunehmende Schichtbildung voranschreitet. Insbesondere bei Kühlung bspw. in Küchenbereichen werden die Wärmetauscher einer hohen Luftfeuchtigkeit ausgesetzt. Im ungünstigsten Fall werden die Wärmetauscher dabei nicht kontinuierlich genutzt, so daß ein kalter Wärmetauscher bei ungünstigen Umgebungsbedingungen sogar Kondenswasserproblemen ausgesetzt wird. Auch in Getränkekühlsystemen ist naturgemäß mit extremer Feuchtigkeitsbelastung zu rechnen. Durch diesen Effekt der Schutzschichtbildung geht so der durch die Porosität verbesserte Wärmeaustausch im Zeitverlauf wieder verloren. Die Wärmetauscherleistung nimmt hier nach und nach mehr und mehr ab.

Da die Patina, anders als der wasserlösliche Grünspan nur schwer zu entfernen ist und außerdem eine regelmäßige Reinigung des Kupfers von dieser Patina-Schicht sofort wieder zur Neubildung führt, kommt eine Reinigung hierzu praktisch nicht in Frage. Dieses Problem verstärkt sich noch bei den gesinterten Wärmetauschern mit ihrer hohen Porösität und großen Oberfläche. Bei der hier gewollten Porosität des Wärmetauschers ist eine Entfernung der Patina praktisch nicht mehr möglich.

Einen gewissen Erfolg kann man allerdings mit einem geometrisch geschickten Aufbau des Kühlkörpers erzielen. Es ist nämlich so, daß die Häufigkeit und Dauer von Wasserfilmen auf der Kupferoberfläche einen wesentlichen Einfluß auf die Oxidationsgeschwindigkeit haben. So haben etwa flachgeneigte oder gar waagerechte Flächen eine viel schnellere Oxidation zur Folge als steile oder senkrechte Flächen, da bei diesen Niederschläge zumindest ablaufen können und somit tendenziell trockener sind. Führt man daher bei einem Wärmetauscher den Kühlkörper senkrecht auf der wärmeabgebenden Fläche angebracht aus, so ergibt sich zumindest bei Eindringen von Feuchtigkeit oder feuchtem Kühlmedium ein schneller Abfluß, was eine gewisse Verbesserung bringt. Diese Lösung kann das Problem - die Schichtbildung - jedoch nur verlangsamen, aber nicht verhindern.

Hingegen hat die Sorte oder der Festigkeitszustand des Kupfers keinen Einfluß auf die Patina. Eine spezielle Materialauswahl beim Kupfer scheidet somit zur Problemlösung aus.

Erfindungsgemäß können zur Lösung dieses Problems als wärmeleitende Materialien Metalle Verwendung finden und zwar als besser wärmeleitendes Material ein im Vergleich zum schlechter wärmeleitenden Material edleres Metall und als schlechter wärmeleitendes Material ein im Vergleich zum besser wärmeleitenden Material unedleres Metall. Hierbei schützt dann das edlere besser wärmeleitende Metall das unedlere. schlechter wärmeleitende vor der Schichtbildung und leistet somit synergetisch zwei Dinge gleichzeitig, nämlich die Verbesserung der Wärmeableitung im Kühlkörper und den Schutz des unedleren Metalls.

Vorzugsweise kann als besser wärmeleitendes Material Silber und als schlechter wärmeleitendes Material Kupfer verwendet werden.

Gesinterte Teile sind in nahezu allen benötigten Formen besonders leicht herzustellen. Unter der Sintertemperatur ist dabei die Temperatur zu verstehen, bei der das Material zu versintern beginnt, d.h. die gekörnten Ausgangsmaterialien an ihren Korngrenzen zueinander miteinander verschmelzen und dabei Verbindungen, sogenannte Sinterhälse eingehen. Im Falle einer gemischten Struktur aus zwei gesinterten Materialien bildet die Struktur aus dem schlechter wärmeleitendem Material, etwa Kupfer nun die Trägerstruktur für das gleichfalls gesinterte besser wärmeleitende Material Silber. So ist es möglich Materialstrukturen aufzubauen, in denen eine geringere Menge des besser wärmeleitenden und in der Regel auch viel teureren Materials dazu verwendet wird, die Wärme vom zu kühlenden Medium in die Kühlkörperstruktur hinein so schnell als möglich wegzuleiten und im Kühlkörper zu verteilen. Hier in der Kühlkörperstruktur kann die Wärmeableitung auf das Kühlmedium dann von einer größeren Menge von dem meist viel billigeren und schlechter wärmeleitenden Material, vorzugsweise Kupfer, übernommen werden. Voraussetzung hierfür ist jedoch, daß in einem Sinterprozeß zunächst die Trägerstruktur aus dem schlechter wärmeleitenden Material aufgebaut werden kann und es hernach möglich ist, das besser wärmeleitende Material in diese Trägerstruktur hinein zu sintern. Dazu ist es erforderlich, daß die Sintertemperatur des besser leitenden Materials unterhalb oder höchstens gleich der Sintertemperatur des schlechter wärmeleitenden Materials liegt, da ansonsten in dem zweiten Sinterprozeß im Ofen die Trägerstruktur zerschmelzen würde und somit unbrauchbar wäre.

Die Sintertemperatur hängt im wesentlichen vom Schmelzpunkt des verwendeten Materials, seiner Korngröße und der gewünschten Ausprägung der Sinterhälse ab. Liegt der Schmelzpunkt des besser wärmeleitenden Materials jedoch in ausreichendem Abstand unterhalb des Schmelzpunktes des schlechter wärmeleitenden Materials, so lassen sich die für die vorstehend beschriebene Versinterung zweier Materialien notwendigen Voraussetzungen in der Regel schaffen, da dann genügend Spielraum für die Sintertemperaturen verbleibt.

Dies gilt insbesondere für Silber und Kupfer, da Silber einen Schmelzpunkt von ca. 961 °C und Kupfer einen Schmelzpunkt von ca. 1083 °C aufweist, wobei Silber schon ab ca. 200 °C zu versintern beginnt.

Vorzugsweise nimmt der Anteil von dem besser wärmeleitenden Material am Kühlkörper pro Volumeneinheit der gesinterten Kühlkörperteile mit zunehmender Entfernung von dem zu kühlenden Medium ab, da hier dann nach und nach das mehr werdende schlechter wärmeleitende Material die Wärmeleitung der nun schon von dem besser wärmeleitenden Material gut verteilten Wärme übernimmt.

Auch kann der Kühlkörper eine geformte Struktur, vorzugsweise eine Kanalstruktur aus dem besser leitenden Material aufweisen, die die Wärme in den Kühlkörper, vorzugsweise gleichmäßig verteilt. Eine solche Ausführungsform verbessert die schnelle Wärmeableitung und anschließende Verteilung im Kühlkörper noch weiter und ermöglicht es insbesondere auch solche Kühlkörpergeometrien zu wählen, die für einen gleichmäßigen Übergang der beiden wärmeleitenden Materialien vom zu kühlenden Medium weg nicht oder nicht so gut geeignet sind.

Vorzugsweise folgt das besser wärmeleitende Material der Trägerstruktur entlang aller ihrer Formmerkmale, also etwa entlang ausgeformter Kanal-, Säulen, Kegel- oder Kegelteilstrukturen, wie sie etwa zur gleichmäßigen Verteilung des Kühlmediums im Kühlkörper dienen, und verbessert so noch deren wärmeableitende und wärmeverteilende Funktion. Die Formgebung (also etwa die Ausgestaltung der Form für den Ofen) für den zweiten Sinterprozeß hat sich dabei der durch den ersten formgebenden Sinterprozeß erhaltenen Kühlkörperform aus dem schlechter wärmeleitenden Material anzupassen. Sie beschränkt den Freiheitsgrad der Formgebung im zweiten Sinterprozeß. Vorzugsweise wird man für die Formgebung des zweiten Sinterprozesses eine Form wählen, die der Struktur der Form für den ersten Sinterprozeß folgt, jedoch noch etwas Raum für das dann zu versinternde besser wärmeleitende Material läßt. Es kann aber auch eine frei geformte Struktur, die die Trägerstruktur lediglich als Grundfläche benutzt, gewählt werden.

In einer besonders bevorzugten Ausführungsform der vorliegenden Erfindung nimmt der Anteil von dem besser wärmeleitenden Material pro Volumeneinheit der gesinterten Kühlkörperteile mit zunehmender Entfernung von der geformten Struktur aus dem besser leitenden Material ab. Dabei leiten die Kanäle aus besser wärmeleitendem Material die Wärme vom zu kühlenden Medium zunächst weg, um sie dann an einer Stelle im Kühlkörper mittels eines stetigen Materialübergangs zu verteilen, wo die geometrischen Verhältnisse dies zulassen.

Auch kann der Kühlkörper eine Kanalstruktur zur Leitung des Kühlmediums aufweisen, die das Kühlmedium in dem Kühlkörper verteilt. Vorzugsweise soll dies so erfolgen, daß das Kühlmedium dabei möglichst gleichmäßig über den Kühlkörper verteilt wird. In einer Ausführungsform nach der vorliegenden Erfindung kann der Kühlkörper dabei von der Kanalstruktur durchdrungen sein.

Auch kann die Kanalstruktur gebogene Kanäle aufweisen. Sie kann ebenso Kanäle aufweisen, von denen wiederum Kanäle abzweigen, wobei von diesen wiederum Kanäle abgehen, von denen wieder Kanäle verzweigen usw., so daß auf diese Weise eine verästelte Struktur gebildet wird, die in möglichst alle Teile des Kühlkörpers verzweigt. Als besonders günstig hat sich dabei eine Struktur von Kanälen erwiesen, die solchermaßen verästelte und dabei gleichzeitig gebogene Kanäle aufweist. Dies gilt in gesteigertem Maße für die hier beschriebenen porösen Kühlkörper. Ist nämlich der Kühlkörper selbst porös, so folgt das Kühlmedium in den gebogenen Kanälen zwar im wesentlichen immer der Biegung des Kanals, es gelangt jedoch an der Seite der Kanalbegrenzung an der es, durch die Biegung bedingt, beständig anströmt zu einem gewissen Teil immer in die poröse Struktur des Kühlkörpers selbst hinein und verteilt sich solchermaßen schon auf seinem Weg durch die Kanäle selbst in dem Kühlkörper entlang der Kanäle.

Auch kann der Kühlkörper Säulen aufweisen, deren Zwischenräume untereinander im wesentlichen die Kanalstruktur bilden. Denkbar sind auch Kegel oder Kegelteile, deren Zwischenräume untereinander im wesentlichen die Kanalstruktur bilden, wobei diese Kühlkörperkegel oder Kühlkörperkegelteile mit ihrer Kegelspitze oder abgeflachten Kegelspitze alle in die gleiche Richtung weisen können oder auch so angeordnet werden können, daß unmittelbar benachbarte Kühlkörperkegel oder Kühlkörperkegelteile, paarweise betrachtet, mit ihrer Kegelspitze oder abgeflachten Kegelspitze jeweils in die Gegenrichtung zeigen.

Durch diese Strukturen wird das anströmende Kühlmedium gezwungen, den Kühlkörper mäanderförmig zu durchströmen und sich so möglichst gleichmäßig über den gesamten Kühlkörper zu verteilen.

Selbstverständlich sind auch beliebige Kombinationen der vorstehenden Wärmeableitungsmöglichkeiten, durch geformte Strukturen einerseits und ineinander übergehende Strukturen andererseits möglich, um den Wärmetauscher so möglichst gut an die meist durch äußere Einflüsse (wie etwa Platzmangel) vorgegebenen geometrischen Abmessungen für den zu verwendenden Kühlkörper anpassen zu können.

Mit Hilfe eines solchen Kühlkörperaufbaus lassen sich sogar die durch die WO 99/09594 gelehrten mäanderförmigen Kühlkörper so verbessern, daß selbst im Falle ihrer Geometrie noch eine gleichmäßige Wärmeverteilung im Kühlkörper erzielt wird, indem im Bereich der Anströmkanalenden der dortige Sinterkühlkörper so ausgeführt wird, daß er in diesem Bereich einen hohen Anteil von besser wärmeleitendem Material aufweist, welcher dann entlang der Anströmkanalseitenwände zugunsten des schlechter wärmeleitenden Materials geringer wird. Kanäle als geformte Strukturen aus besser wärmeleitendem Material vom Kanalendstück weg und zu den Seitenwäriden hin vermögen dies noch zu verbessern.

Insbesondere eignen sich diese erfindungsgemäß aufgebauten Wärmetauscher auch dazu, solche Kühlfunktionen zu erfüllen, bei denen eine Kühlung nur in, vorzugsweise kürzeren, Intervallen oder nur unregelmäßig oder nur für eine jeweilig zeitlich begrenzte, vorzugsweise kurze Dauer benötigt wird. In diesen Fällen führt die schnelle Weiterleitung der Wärme in den Kühlkörper, wo sie dann vom Kühlmedium endgültig abgeleitet wird, dazu, daß in vielen Fällen auf einen Lüfter verzichtet werden kann, wenn der Kühlkörper genügend groß dimensioniert ist, wobei der weitaus größte Bereich aus dem schlechter wärmeleitenden Material besteht, was dann gleichsam als Wärmezwischenpuffer wirkt. Der so gewonnene Verzicht auf einen Lüfter stellt nicht nur einen Kostenvorteil, sondern auch einen Vorteil hinsichtlich der verminderten Stromaufnahme wie auch der geringeren Geräuschentwicklung dar. In den Fällen, in denen auf einen Lüfter zwar nicht gänzlich verzichtet werden kann, kann dieser jedoch durch einen Wärmetauscher nach der vorliegenden Erfindung oft erheblich kleiner ausgelegt werden, als dies ohne einen solchen möglich gewesen wäre.

Die aus einer Materialkombination, nämlich einem schlechter und einem besser wärmeleitendem Material hergestellten erfindungsgemäßen Wärmetauscher zeigen insgesamt gesehen eine erheblich verbesserte Leistung, da das besser wärmeleitende Material die Wärme schneller im Kühlkörper auf das schlechter leitende Material verteilt, das jedoch die Wärme dann aufgrund seines größeren Volumens an das Kühlmedium abgeben kann. Besonders deutlich wird dieser Effekt am Beispiel von Kupfer und Silber deren Wärmeleitzahl im Falle von Kupfer 384 und Silber 407 beträgt, der Preis von Silber gleichzeitig jedoch bei einem Vielfachen von dem von Kupfer liegt. Hier wird also nur eine geringe Menge des teuren Silbers benötigt, um die Wärme in ein großes Volumen Kupfer hinein zu verteilen, welches sie dann an das Kühlmedium abgibt. Ein Blick auf die relative Leitfähigkeit anderer Materialien zeigt, daß hier auch noch andere Kombinationen verwendbar sind, so beträgt die relative Leitfähigkeit
- des Vakuums (Referenzwert) 0,
- von Luft 1,
- von Aluminium 9000,
- von Kupfer 16000,
- und von Silber 20000

Auch können die erfindungsgemäßen Wärmetauscher als Kühlelement zur Kühlung einer Achse dienen, indem ein Materialkörper, vorzugsweise ein Stab, etwa ein Rundstab, aus dem besser wärmeleitenden Material innerhalb der zu kühlenden Achse im wesentlichen in Kontakt mit den zu kühlenden Achselementen steht und die Wärme von hier zu dem hinter mindestens einem Achsende angeordneten schlechter wärmeleitenden Material hin ableitet, welches dort im wesentlichen in Kontakt mit dem Kühlmedium steht, auf das es seinerseits die Wärme überträgt. Der Materialkörper kann dabei auch aus gesintertem Material bestehen. Auch kann der Materialkörper aus dem besser wärmeleitenden Material gegenüber den Achselementen, die nicht zu kühlen sind, isoliert werden. Eine solche Isolation kann etwa dergestalt ausgeführt sein, daß ein hoch wärmeleitender Stab innerhalb einer Isolationsachse angeordnet ist.

Vorzugsweise ist hinter mindestens einem Achsende ein mit der Achse rotierender Kühlkörperteil angeordnet, der entgegen der Rotationsrichtung gebogene Kühlrippen aufweist, was die Kühlwirkung noch verstärkt, wobei der rotierende Kühlkörperteil selbst entsprechend der vorliegenden Erfindung aus zumindest zwei Materialien, nämlich einem besser wärmeleitendem und einem schlechter wärmeleitendem beschaffen sein kann.

In einer besonders bevorzugten Ausführungsform eines Wärmetauschers nach der vorliegenden Erfindung ist zwischen dem Materialkörper aus dem besser wärmeleitenden Material und dem rotierenden Kühlkörperteil ein Peltierelement angebracht, welches mit seiner kühlenden Seite im wesentlichen in Kontakt zu dem Materialkörper aus dem besser wärmeleitenden Material und mit seiner wärmeabgebenden Seite im wesentlichen in Kontakt zu dem rotierenden Kühlkörperteil steht, so daß hierdurch die Ableitung der Wärme noch weiter verbessert wird.

Die erfindungsgemäßen Wärmetauscher mit gesintertem Kühlelement und poröser Sinterstruktur können auch so gefertigt werden, daß, anstatt gesintert zu werden, ihr gekörntes Ausgangsmaterial mittels Bestrahlung durch Mikrowellen miteinander verbunden wird und so eine sinterähnliche poröse Struktur bildet, welche von dem Kühlmedium durchströmt werden kann.

Dabei werden genau wie beim Versintern von gekörnten Materialien, wie etwa Metallpulvern, Negativ-Formen der zu erzeugenden Gegenstände, etwa der Kühlkörper, mit dem gekörnten Material befüllt und dann der Mikrowellenstrahlung ausgesetzt. Die gekörnten Materialien gehen dabei wie beim Sintern an ihren jeweiligen Kontaktstellen Verbindungen ein. Im Gegensatz zum Sintern ergeben sich hierbei jedoch weniger Verklumpungsprobleme. Die Ausprägung der Sinterhälse ist besser reproduzierbar, was die Fertigung im Hinblick auf gleichmäßige Qualitäten erheblich vereinfacht. Anders als feste Metalle absorbieren Metallpulver in Abhängigkeit ihrer Korngröße die energiereichen Wellen eher als sie zu reflektieren.

Hierbei ergeben sich Strukturen, die eine noch bessere Wärmeleitfähigkeit aufweisen als gesinterte Teile. Auch ist die Stoßfestigkeit dieser Teile verbessert, was insbesondere Einsatzgebieten, in denen Wärmetauscher Erschütterungen ausgesetzt sind, wie etwa in Fahrzeugen, zum Vorteil gereicht; ihre Lebensdauer verlängert sich, die Bruchgefahr sinkt.

All diese Ausführungsformen sind jedoch originär gesinterten Teilen in ihrer Kühlfunktion gleichwertig.

Um erfindungsgemäße Wärmetauscher herzustellen, bei denen die gesinterten Teile aus einem besser wärmeleitenden Material und einem schlechter wärmeleitenden Material bestehen und auch diese beiden Materialien miteinander eine poröse Sinterstruktur bilden, wobei die Sintertemperatur des besser wärmeleitenden Materials kleiner oder gleich der Temperatur des schlechter wärmeleitenden Materials ist, eignet sich folgendes Verfahren:

Zunächst wird eine Form mit dem für den Wärmetauscher benötigten schlechter wärmeleitenden Material beschickt. Sodann wird die Form auf eine zum Sintern des schlechter wärmeleitenden Materials erforderliche Temperatur gebracht. Die Form wird nun auf eine Zwischenabkühltemperatur abgekühlt, falls notwendig werden dann Veränderungen an der Form vorgenommen (etwa um eine dem besser wärmeleitenden Material angepaßte Struktur zu erzeugen). Als Zwischenabkühltemperatur dient dabei vorzugsweise die normale Umgebungstemperatur der Luft, jedoch reicht es, vorzugsweise dann, wenn keine Veränderungen an der Form vorgenommen werden, auch die Form auf eine Temperatur unterhalb von 200 °C, vorzugsweise etwa auf 100 °C abzukühlen. Sodann wird die Form mit dem für den Wärmetauscher benötigten besser wärmeleitenden Material beschickt und hernach auf eine zum Sintern des besser wärmeleitenden Materials erforderliche Temperatur gebracht, wobei diese Temperatur kleiner oder gleich der liegt, die zum Sintern des schlechter wärmeleitenden Materials erforderlichen maximalen Temperatur benötigt wird. Schließlich kann die Form auf eine Endtemperatur des Verfahrens abkühlen. Als Endtemperatur dient dabei vorzugsweise die normale Umgebungstemperatur der Luft.

Vorzugsweise wird in diesem Verfahren die Form nach der Beschickung mit schlechter wärmeleitendem Material und in Zwischenschritten auf eine oder mehrere Zwischentemperaturen gebracht, bevor die zum Sintern dieses Materials erforderliche Temperatur erreicht wird.

Ebenso kann auch in Zwischenschritten wieder auf die Zwischenabkühltemperatur heruntergefahren werden.

Entsprechendes gilt auch für das Sintern des zweiten besser wärmeleitenden Materials. Auch hier kann das Anfahren der Sintertemperatur ebenso wie das Absenken wiederum in Zwischenschritten erfolgen.

Als besser wärmeleitendes Material eignet sich hierbei vorzugsweise Silber und als schlechter wärmeleitendes Material Kupfer. Dabei läuft das Verfahren wie folgt ab:
- Zunächst wird eine Form mit dem für den Wärmetauscher benötigten Kupfer beschickt.
- Sodann wird die Form zum Sintern des Kupfers für etwa 12 Minuten auf 1.073 °C gebracht. (Alternativ kann sie auch für etwa 10 Minuten auf 1.075 °C oder für etwa 8 Minuten auf 1.077 °C oder für etwa 6 Minuten auf 1079 °C gebracht werden)
- Hieran anschließend kann die Form nun auf eine Zwischenabkühltemperatur von 100 °C abkühlen.
- Falls notwendig, werden nun Veränderungen an der Form für das zu sinternde Silber vorgenommen.
- Dann wird die Form mit dem für den Wärmetauscher benötigten Silber beschickt.
- Sodann wird die Form zum Sintern des Silbers für etwa 12 Minuten auf 900 °C gebracht. (Alternativ kann sie auch für etwa 10 Minuten auf 920 °C oder für etwa 8 Minuten auf 935 °C oder für etwa 6 Minuten auf 950 °C gebracht werden.) Diese Temperaturen sind dabei kleiner als oder gleich wie die zum Sintern des schlechter wärmeleitenden Kupfers erforderlichen Temperaturen.
- Zum Abschluß kann die Form dann abkühlen.

In einer weiteren besonders bevorzugten Ausführungsform läuft das erfindungsgemäße Verfahren so ab, daß der Schritt zum Sintern des Kupfers bei niedriger Temperatur eine längere Zeit andauert und bei höherer Temperatur eine kürzere Zeit und zwar in folgendem Bereich, nämlich 20 Minuten Dauer bei 1000°C bis hin zu 2 Minuten Dauer bei 1100 °C und auch der Schritt zum Sintern des Silbers bei niedriger Temperatur eine längere Zeit andauert und bei höherer Temperatur eine kürzere Zeit und zwar in folgendem Bereich, nämlich 20 Minuten Dauer bei 200°C bis hin zu 2 Minuten Dauer bei 990 °C. Vorzugsweise steigt dabei in den jeweiligen Bereichen die Zeit umgekehrt proportional zur sinkenden Temperatur an. Dieses gilt sinngemäß natürlich nicht nur für Kupfer und Silber, sondern auch für andere geeignete schlechter und besser wärmeleitenden Materialien, wobei die Temperaturen entsprechend dem jeweiligen Material anzupassen sind

Vorzugsweise werden die erfindungsgemäßen Sinterverfahren im Sinterofen unter Schutzgas, etwa Wasserstoff durchgeführt.

Der Sinterprozeß kann aber auch unter Abdeckung der Sinterform mit, vorzugsweise schwefelarmer, Holzkohle durchgeführt werden. Hierbei wird die Holzkohle oben auf die Form zur Abdeckung aufgebracht, etwa im Falle einer abgeschlossenen Form mit Deckel. Auf diese Weise verbrennt sie den bei der Temperaturerhöhung verbleibenden Sauerstoff in der Form. Aus der Gießereitechnik ist nämlich bekannt, daß Sauerstoff in der Schmelze zu Lunkern führt, was Mängel in der Oberfläche hervorruft. Der Vorteil der Holzkohle besteht, im Falle der Verwendung von Kupfer zum Sintern darin, daß Kupfer, anders als etwa Stahl, nicht mit Kohlenstoff reagiert und die Holzkohle während des Erhitzungsprozesses den Sauerstoff fernhält, in dem sie mit ihm reagiert. Es ist jedoch darauf zu achten, daß die Holzkohle möglichst schwefelarm ist, da ein zu hoher Schwefelanteil zu Materialbruchstellen führen kann.

Der für das Sinterverfahren eingesetzte Ofen muß über eine hohe Temperaturgenauigkeit verfügen (etwa Fabrikate Alino Düren, Brands Düren oder auch geeignete Lötöfen). Die Sinterhalsausprägungen (ca. 30 % sind angestrebt) können über eingesetzte Korngröße des Materials, die Temperaturen und Verweildauern beeinflußt werden.

Im folgenden werden nicht einschränkend zu verstehende Ausführungsbeispiele anhand der Zeichnung besprochen. In dieser zeigen:
- Fig. **1**: ein Beispiel einer Sinterofenform im Schnitt von der Seite her,
- Fig. **2**: ein Beispiel einer Sinterofenform zur Herstellung von Kühlkörpern, die Säulen oder Kegel bzw. Kegelteile aufweisen in Aufsicht von oben her,
- Fig. **3**: ein Beispiel einer Sinterofenform anhand der veranschaulicht werden soll, wie Kühlkörper aus 2 Materialien gesintert werden, dies im Schnitt von der Seite her,
- Fig. **4**: ein Beispiel eines gesinterten Kühlkörpers, der überwiegend aus einem schlechter wärmeleitenden Material, etwa Kupfer, besteht, in Aufsicht,
- Fig. **5**: ein Beispiel eines gesinterten Kühlkörpers, der überwiegend aus einem schlechter wärmeleitenden Material, etwa Kupfer, besteht, in perspektivischer Ansicht,
- Fig. **6**: einen gesinterten Kühlkörper in Aufsicht, bei dem die gesinterten Teile aus einem besser wärmeleitenden Material (z.B. Silber) und einem schlechter wärmeleitenden Material (z.B. Kupfer) bestehen,
- Fig. **7**: einen Wärmetauscher, der aus mehreren Kühlkörpern aufgebaut ist,
- Fig. **8a**: und 8b einen Wärmetauscher als Kühlelement zur Kühlung einer Achse in Seitenansicht,
- Fig. **9**: einen weiteren Wärmetauscher als Kühlelement zur Kühlung einer Achse unter Verwendung eines Peltierelements,
- Fig. **10**: noch einen Wärmetauscher als Kühlelement zur Kühlung einer Achse mit einem Rotationskühlkörperteil, das gebogene Rippen aufweist, und
- Fig. **11**: und **11a** wiederum einen weiteren erfindungsgemäßen Wärmetauscher zur Kühlung einer Achse aus zwei Materialien.

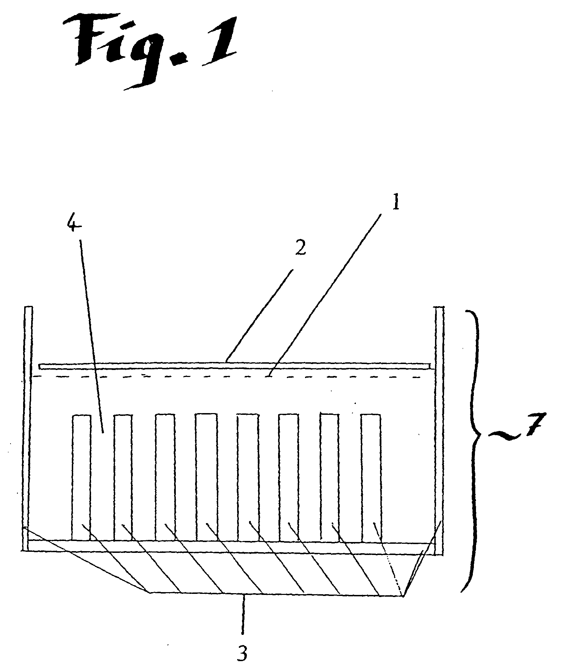

Fig. **1** zeigt ein Beispiel einer Sinterofenform im Schnitt von der Seite her, die mit dem zu versinternden Material bis zu einer Befüllhöhe **1** beschickt wird. In Befüllhöhe **1** kann dabei eine Abdeckplatte **2** aufgelegt werden, die entweder nur zur Glättung dient und vor dem eigentlichen Ofenprozeß wieder entfernt wird oder aber selbst zum Bestandteil des Kühlkörpers wird. In letzterem Falle ist die Platte vorzugsweise in dem gleichen Material ausgeführt wie das Sintermaterial, mit dem die Form beschickt wird oder aber sie wird in einem zweiten Fertigungsschritt in einem besser wärmeleitenden Material, vorzugsweise Silber, ausgeführt. In diesem Falle sintert das besser wärmeleitende Material der Platte während des Sinterprozesses auch in die zuvor gesinterte Trägerstruktur aus schlechter wärmeleitendem Material hinein. Die Form weist weiterhin negativ ausgeformte Strukturen **3**, hier in Form von Rippen auf, die dem Sintermaterial ihre Form aufprägen. Das Sintermaterial selbst wird in den von dieser Form freigelassenen Raum **4** befüllt, um dann im Ofen verarbeitet zu werden.

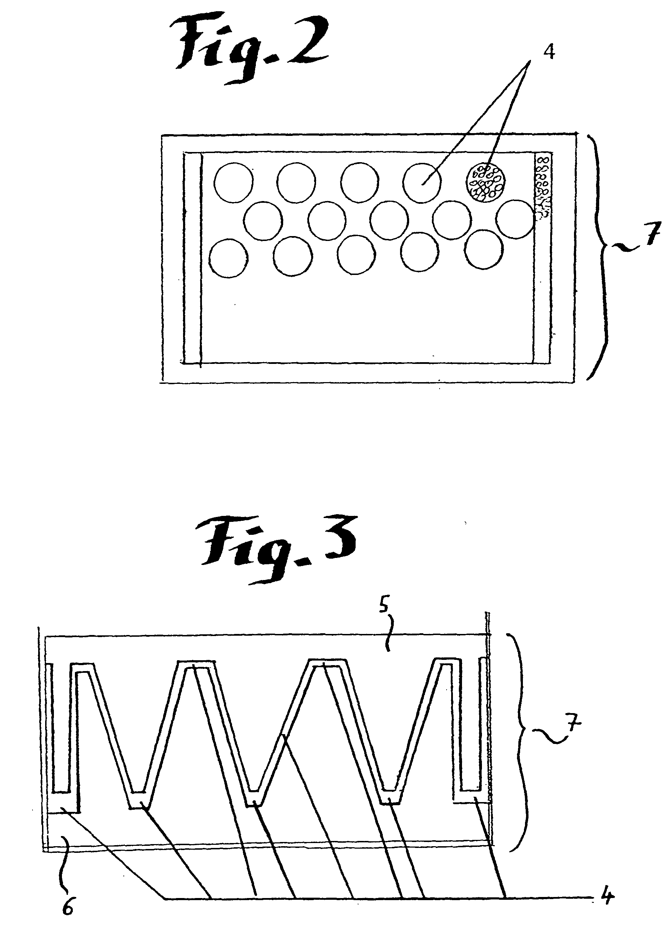

Fig. **2** zeigt ein Beispiel einer Sinterofenform in Aufsicht von oben her zur Herstellung von Kühlkörpern die Säulen oder Kegel bzw. Kegelteile aufweisen. Das zu sinternde Material wird dabei in den von dieser Form frei gelassenen Raum **4** befüllt und bildet so die gewünschte Form.

Fig. **3** zeigt ein Beispiel einer Sinterofenform **7** im Schnitt von der Seite her, anhand der veranschaulicht werden soll, wie Kühlkörper aus 2 Materialien gesintert werden. Um einen aus zwei Materialien gesinterten Kühlkörper zu fertigen, wird das schlechter wärmeleitende Material, welches vorzugsweise in Pulverform vorliegt in eine Form eingebracht, die aus einem oberen Teil **5** und einem unteren Teil **6** besteht. Dies geschieht beispielsweise derart, daß der untere Teil der Form **6** zunächst ausreichend mit Metallpulver befüllt wird, worin dann der obere Formteil **5** hineingedrückt wird. Durch hinreichendes Rütteln und Schütteln wird das zu sinternde Metallpulver dann in dem dann noch von der Form frei gelassenen Raum **4** verteilt, wobei dies Verteilen auch durch Befüllen und Kippen der Form geschehen kann. Sodann kann die solchermaßen beschickte Form im Ofen aufgeheizt werden.

Nachdem diese erste Verarbeitungsstufe abgeschlossen ist, wird der obere Formteil **5** durch einen neuen Formteil ersetzt, welcher nun einen neuen Raum zwischen dem in der ersten Stufe gesinterten Körper und der Form freiläßt. Hierin wird nun das zweite besser wärmeleitende Material befüllt und im weiteren wie bei dem zuerst verarbeiteten Material verfahren. Das zweite besser wärmeleitende Material nutzt so das erste schlechter wärmeleitende Material als Trägerstruktur bei seiner Sinterung.

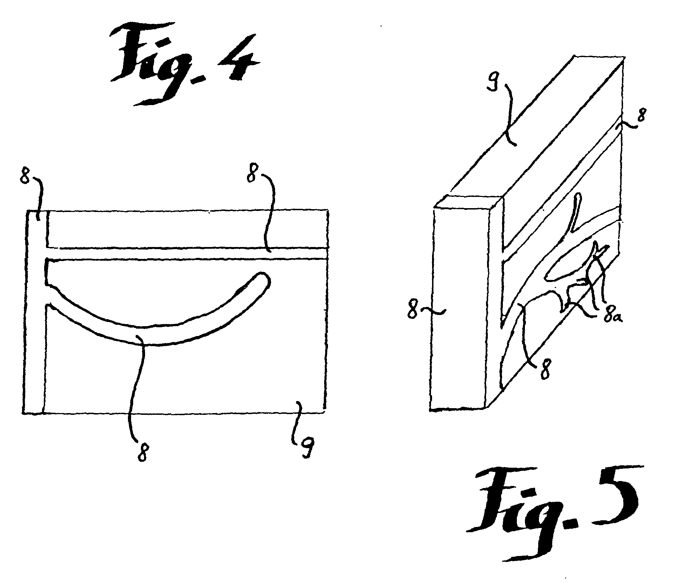

Fig. **4** zeigt ein Beispiel eines gesinterten Kühlkörpers **9**, der überwiegend aus einem schlechter wärmeleitenden Material, etwa Kupfer besteht, in Aufsicht. Zusätzlich weist er jedoch geformte Strukturen (etwa Rippen) **8** aus einem besser wärmeleitenden Material, vorzugsweise Silber, auf, die die vom zu kühlenden Medium abzuführende Wärme in den Kühlkörper **9** verteilt.

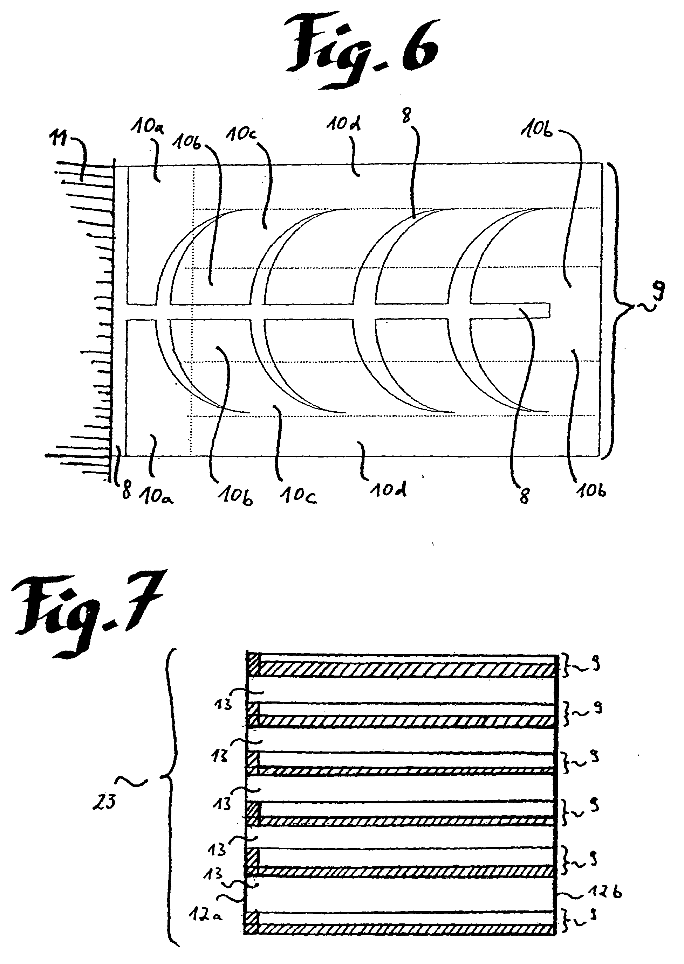

Fig. **5** zeigt ein Beispiel eines gesinterten Kühlkörpers **9**, der überwiegend aus einem schlechter wärmeleitenden Material, etwa Kupfer besteht, in perspektivischer Ansicht. Auch er weist geformte Strukturen (hier Kanäle) **8** aus einem besser wärmeleitenden Material, vorzugsweise Silber, auf, die die vom zu kühlenden Medium abzuführende Wärme in den Kühlkörper **9** verteilen. Die Kanäle **8** sind dabei auch gebogen und verzweigen wiederum in weitere Kanäle, so daß eine verästelte Struktur mit feinen Kanalenden **8a** entsteht, die in den Kühlkörper **9** hineinreicht.

Statt oder zusätzlich zu einer Silberkanalstruktur **8** ist auch eine Hohlkanalstruktur gleichen oder ähnlichen Aufbaus möglich, durch die ein Kühlmedium in den Kühlkörper **9** hineingeleitet werden kann.

Fig. **6** zeigt einen gesinterten Kühlkörper **9** in Aufsicht, bei dem die gesinterten Teile aus einem besser wärmeleitenden Material (z.B. Silber) und einem schlechter wärmeleitenden Material (z.B. Kupfer) bestehen und diese beiden Materialien miteinander eine poröse Sinterstruktur bilden und der Kühlkörper desweiteren eine geformte Struktur **8** aus dem besser leitenden Material aufweist, die die Wärme in den Kühlkörper **9** verteilt, wobei der Anteil von dem besser wärmeleitenden Material im Kühlkörper pro Volumeneinheit der gesinterten Kühlkörperteile sowohl mit zunehmender Entfernung von dem zu kühlenden Medium **11** wie auch mit zunehmender Entfernung von der Kanalstruktur **8** aus dem besser leitenden Material abnimmt. So ergibt sich ein besonders hoher Anteil des besser wärmeleitenden Materials in Zone **10 a**, die sowohl in der Nähe des zu kühlenden Mediums **11**, wie auch in der Nähe der Kanalstruktur **8** liegt. Auch in Zone **10b**, die überwiegend in der Nähe der Kanalstruktur **8** liegt, ist dieser Anteil noch hoch, wohingegen er in Zone **10c** schon geringer ausfällt und schließlich in Zone **10d** minimal wird. Auf diese Weise wird eine besonders gute Wärmeverteilung in den Kühlkörper hinein erreicht.

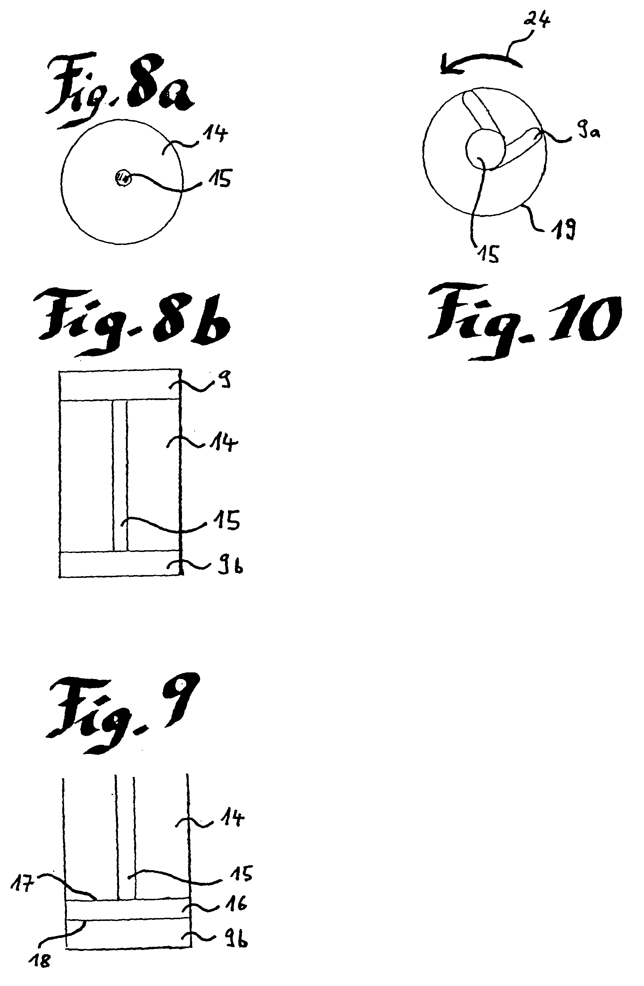

Fig. **7** zeigt einen Wärmetauscher **23**, der aus mehreren Kühlkörpern **9** (wie sie beispielsweise in Fig. **6** zu sehen sind) schichtweise zwischen zwei Begrenzungen **12a** und **12b** aufgebaut ist und bei dem zwischen den einzelnen Kühlkörpern **9** Zwischenräume **13** bestehen, durch die ein Kühlmedium, beispielsweise Luft zu den Kühlkörpern **9** hingeleitet werden kann.

Fig. **8a** und **8b** zeigen einen Wärmetauscher als Kühlelement zur Kühlung einer Achse **14,** in Seitenansicht (Fig. **8a**), wie auch in Aufsicht (Fig. **8b**), bei dem ein Materialkörper **15** aus besser wärmeleitendem Material innerhalb der zu kühlenden Achse **14** im wesentlichen in Kontakt mit den zu kühlenden Achselementen steht und die Wärme von hier zu dem hinter mindestens einem Achsende angeordneten Kühlkörperteil **9b** hin ableitet. Dabei besteht das Kühlkörperteil **9b** hier selbst aus zwei Materialien, nämlich aus dem besser wärmeleitenden Material, aus dem auch der Materialkörper **15** besteht und einem schlechter wärmeleitenden Material, welches im wesentlichen in Kontakt mit dem Kühlmedium steht, auf das es seinerseits die Wärme überträgt. Durch die Anordnung dieses Kühlkörperteiles **9b** hinter mindestens einem Achsende wird somit erreicht, daß auch das schlechter wärmeleitende Material, welches im wesentlichen in Kontakt mit dem Kühlmedium steht, hinter mindestens einem Achsende liegt. Auch ist hier das Kühlkörperteil **9b** so beschaffen, daß es gesinterte Teile aufweist, die eine poröse Sinterstruktur bilden, welche von dem Kühlmedium durchströmt werden kann, wobei gesinterte Teile aus dem besser wärmeleitenden Material und dem schlechter wärmeleitenden Material bestehen und die Sintertemperatur des besser wärmeleitenden Materials kleiner oder gleich der Temperatur des schlechter wärmeleitenden Materials ist.

Fig. **9** zeigt einen Wärmetauscher als Kühlelement zur Kühlung einer Achse nach Fig. **8a, 8b,** wobei hier zwischen dem Materialkörper **15** und dem Kühlkörperteil **9b** noch ein Peltierelement **16** zur weiteren Verbesserung der Wärmeableitung angeordnet ist. Die kalte Seite **17** des Peltierelements ist dabei dem Materialkörper **15** und die warme Seite des Elements **18** dem Kühlkörperteil **9b** zugewandt.

Fig. **10** zeigt einen Wärmetauscher als Kühlelement zur Kühlung einer Achse nach Fig. **8a**, **8b**, wobei hier das Kühlkörperteil als rotierendes Kühlkörperteil **9a** mit entgegen der Rotationsrichtung der Achse gebogene Kühlrippen ausgeführt ist, die durch ein sie auf dem Umfang umfassendes Stabilisierungsband **19** gehalten werden.

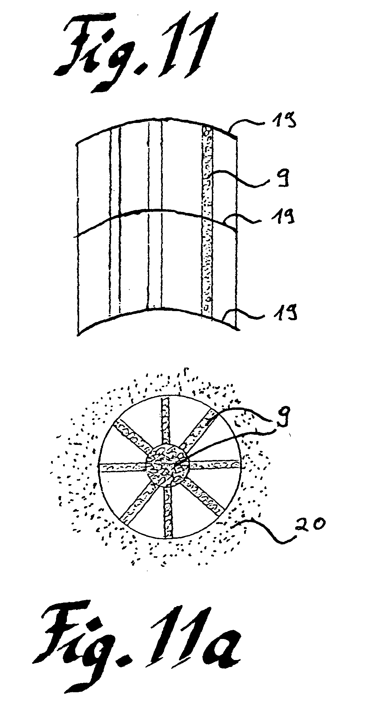

Fig. **11** und **11a** zeigen einen Wärmetauscher, der ein Kühlkörperteil **9** aufweist, der einerseits mit einem zu kühlenden Medium und andererseits mit einem Kühlmedium **20** in Kontakt steht und die Wärme des zu kühlenden Mediums auf das Kühlmedium **20** überträgt, wobei das Kühlkörperteil **9** aus mindestens zwei Materialien besteht, von denen das eine besser wärmeleitend ist als das andere, und das besser wärmeleitende Material im wesentlichen in Kontakt mit den zu kühlenden Achselementen steht und die Wärme von diesem zu dem schlechter wärmeleitenden Material hin ableitet, welches im wesentlichen in Kontakt mit dem Kühlmedium **20** steht, auf das es seinerseits die Wärme überträgt. Die Struktur wird dabei von Stabilisierungsbändern **19** zusammengehalten.

## Patentansprüche

1. Wärmetauscher, der einen Kühlkörper (**9**) aufweist, der einerseits mit einem zu kühlenden Medium (**11**) und andererseits mit einem Kühlmedium (**20**) in Kontakt steht und die Wärme des zu kühlenden Mediums auf das Kühlmedium überträgt, wobei
der Kühlkörper (**9**) gesinterte Teile aufweist, die eine poröse Sinterstruktur bilden, welche von dem Kühlmedium durchströmt werden kann,
**dadurch gekennzeichnet,**
**daß** der Kühlkörper mindestens aus zwei Materialien besteht, von denen das eine besser wärmeleitend ist als das andere, und das besser wärmeleitende Material im wesentlichen in Kontakt mit dem zu kühlenden Medium steht und die Wärme vom diesem zu dem schlechter wärmeleitenden Material hin ableitet, welches im wesentlichen in Kontakt mit dem Kühlmedium steht, auf das es seinerseits die Wärme überträgt,
wobei das schlechter wärmeleitende Material als Trägerstruktur für das gleichfalls gesinterte besser wärmeleitende Material dient,
sowie gesinterte Teile aus dem besser wärmeleitenden Material und dem schlechter wärmeleitenden Material bestehen
und die Sintertemperatur des besser wärmeleitenden Materials kleiner oder gleich der Sintertemperatur des schlechter wärmeleitenden Materials ist.

2. Wärmetauscher nach Anspruch 1, **dadurch gekennzeichnet, daß** als wärmeleitende Materialien Metalle Verwendung finden und zwar als besser wärmeleitendes Material ein im Vergleich zum schlechter wärmeleitenden Material edleres Metall und als schlechter wärmeleitendes Material ein im Vergleich zum besser wärmeleitenden Material unedleres Metall.

3. Wärmetauscher nach Anspruch 2, **dadurch gekennzeichnet, daß** als besser wärmeleitendes Material Silber und als schlechter wärmeleitendes Material Kupfer verwendet wird.

4. Wärmetauscher nach Anspruch 1, 2 oder 3, **dadurch gekennzeichnet, daß** der Anteil von dem besser wärmeleitenden Material am Kühlkörper pro Volumeneinheit der gesinterten Kühlkörperteile mit zunehmender Entfernung von dem zu kühlenden Medium (**11**) abnimmt.

5. Wärmetauscher nach einem der Ansprüche 1 bis 4, **dadurch gekennzeichnet, daß** der Kühlkörper eine geformte Struktur aus dem besser leitenden Material (**8**) aufweist, die die Wärme in den Kühlkörper (**9**) verteilt.

6. Wärmetauscher nach Anspruch 5, **dadurch gekennzeichnet, daß** der Anteil von dem besser wärmeleitenden Material am Kühlkörper pro Volumeneinheit der gesinterten Kühlkörperteile mit zunehmender Entfernung von der geformten Struktur (**9**) aus dem besser leitenden Material abnimmt.

7. Wärmetauscher nach einem der Ansprüche 1 bis 6, **dadurch gekennzeichnet, daß** der Kühlkörper eine Kanalstruktur (**8, 8a**) zur Leitung des Kühlmediums aufweist, die das Kühlmedium in dem Kühlkörper verteilt.

8. Wärmetauscher nach Anspruch 7, **dadurch gekennzeichnet, daß** die Kanalstruktur gebogene Kanäle aufweist.

9. Wärmetauscher nach Anspruch 7 oder 8, **dadurch gekennzeichnet, daß** die Kanalstruktur (**8**) Kanäle aufweist, von denen wiederum Kanäle (**8a**) abzweigen.

10. Wärmetauscher nach einem der Ansprüche 1 bis 9 als Kühlelement zur Kühlung einer Achse (**14**), **dadurch gekennzeichnet, daß** ein Materialkörper (**15**) aus dem besser wärmeleitenden Material innerhalb der zu kühlenden Achse im wesentlichen in Kontakt mit den zu kühlenden Achselementen steht und die Wärme von hier zum hinter mindestens einem Achsende angeordneten, schlechter wärmeleitenden Material hin ableitet, welches dort im wesentlichen in Kontakt mit dem Kühlmedium steht, auf das es seinerseits die Wärme überträgt.

11. Wärmetauscher nach Anspruch 10, **dadurch gekennzeichnet, daß** der Materialkörper aus dem besser wärmeleitenden Material gegenüber den Achselementen, die nicht zu kühlen sind, isoliert ist.

12. Wärmetauscher nach Anspruch 10 oder 11, **dadurch gekennzeichnet, daß** hinter mindestens einem Achsende ein mit der Achse rotierender Kühlkörperteil (**9a**) angeordnet ist, der entgegen der Rotationsrichtung gebogene Kühlrippen aufweist.

13. Wärmetauscher nach Anspruch 12, **dadurch gekennzeichnet, daß** zwischen dem Materialkörper (**15**) aus dem besser wärmeleitenden Material und dem rotierenden Kühlkörperteil (**9a**) ein Peltierelement (**16**) angebracht ist, welches mit seiner kühlenden Seite (**17**) im wesentlichen in Kontakt zu dem Materialkörper (**15**) aus dem besser wärmeleitenden Material und mit seiner wärmeabgebenden Seite (**18**) im wesentlichen in Kontakt zu dem rotierenden Kühlkörperteil (**9a**) steht, so daß hierdurch die Ableitung der Wärme verbessert wird.

14. Verfahren zur Herstellung eines in Anspruch 1 beanspruchten Wärmetauschers, welches die folgenden Schritte aufweist:
(i) zunächst wird eine Form (**7**) mit dem für den Wärmetauscher benötigten schlechter wärmeleitenden Material beschickt;
(ii) sodann wird die Form auf eine zum Sintern des schlechter wärmeleitenden Materials erforderliche Temperatur gebracht;
(iii) die Form wird nun auf eine Zwischenabkühltemperatur gebracht;
(iv) gegebenenfalls werden nun Veränderungen an der Form vorgenommen;
(v) dann wird die Form mit dem für den Wärmetauscher benötigten besser wärmeleitenden Material beschickt;
(vi) sodann wird die Form auf eine zum Sintern des besser wärmeleitenden Materials erforderliche Temperatur gebracht, wobei diese kleiner oder gleich der zum Sintern des schlechter wärmeleitenden Materials erforderlichen Temperatur liegen muß;
(vii) schließlich wird die Form auf eine Endabkühltemperatur gebracht.

15. Verfahren zur Herstellung eines in Anspruch 1 beanspruchten Wärmetauschers nach Anspruch 14, **dadurch gekennzeichnet, daß** die Form (**7**) nach Schritt (i) und vor Schritt (ii) in einem oder mehreren Zwischenschritten auf eine oder mehrere Zwischentemperaturen gebracht wird.

16. Verfahren zur Herstellung eines in Anspruch 1 beanspruchten Wärmetauschers nach Anspruch 14 oder 15, **dadurch gekennzeichnet, daß** die Form (**7**) nach Schritt (ii) und vor Schritt (iii) in einem oder mehreren Zwischenschritten auf eine oder mehrere Zwischentemperaturen gebracht wird.

17. Verfahren zur Herstellung eines in Anspruch 1 beanspruchten Wärmetauschers nach Anspruch 14, 15 oder 16, **dadurch gekennzeichnet, daß** die Form (**7**) nach Schritt (v) und vor Schritt (vi) in einem oder mehreren Zwischenschritten auf eine oder mehrere Zwischentemperaturen gebracht wird.

18. Verfahren zur Herstellung eines in Anspruch 1 beanspruchten Wärmetauschers nach Anspruch 14, 15, 16 oder 17, **dadurch gekennzeichnet, daß** die Form (**7**) nach Schritt (vi) und vor Schritt (vii) in einem oder mehreren Zwischenschritten auf eine oder mehrere Zwischentemperaturen gebracht wird.

19. Verfahren zur Herstellung eines in Anspruch 1 beanspruchten Wärmetauschers nach Anspruch 14, **dadurch gekennzeichnet, daß** als besser wärmeleitendes Material Silber und als schlechter wärmeleitendes Material Kupfer gewählt wird, und das Verfahren folgende Schritte aufweist:
(i) zunächst wird eine Form (**7**) mit dem für den Wärmetauscher benötigten Kupfer beschickt;
(ii) sodann wird die Form auf die zum Sintern des Kupfers erforderliche Temperatur im Bereich von etwa 1000 °C bis 1100 °C, vorzugsweise 1073°C bis 1079 °C gebracht;
(iii) die Form wird nun auf eine Zwischenabkühltemperatur von 100 °C gebracht;
(iv) gegebenenfalls werden nun Veränderungen an der Form vorgenommen;
(v) dann wird die Form mit dem für den Wärmetauscher benötigten Silber beschickt;
(vi) sodann wird die Form auf die zum Sintern des Silbers erforderliche Temperatur im Bereich von 200 °C bis 990 °C, vorzugsweise von etwa 900°C bis 950 °C gebracht, wobei diese Temperaturen im Bereich von 200°C bis 990 °C kleiner oder gleich der zum Sintern des schlechter wärmeleitenden Kupfers erforderlichen Temperaturen im Bereich von 1000°C bis 1100 °C sind;
(vii) schließlich wird die Form auf eine Endabkühltemperatur gebracht.

20. Verfahren zur Herstellung eines in Anspruch 1 beanspruchten Wärmetauschers nach Anspruch 19, **dadurch gekennzeichnet, daß** die Temperaturen im Bereich von 1073°C bis 1079 °C in Schritt (ii) für etwa 6 bis 12 Minuten gehalten werden und die Temperaturen im Bereich von 900°C bis 950 °C in Schritt (vi) ebenfalls für etwa 6 bis 12 Minuten gehalten werden.

21. Verfahren zur Herstellung eines in Anspruch 1 beanspruchten Wärmetauschers nach Anspruch 19, **dadurch gekennzeichnet, daß** Schritt (ii) bei niedriger Temperatur eine längere Zeit andauert und bei höherer Temperatur eine kürzere Zeit und zwar in folgendem Bereich, nämlich 20 Minuten Dauer bei 1000°C bis hin zu 2 Minuten Dauer bei 1100 °C und auch Schritt (vi) bei niedriger Temperatur eine längere Zeit andauert und bei höherer Temperatur eine kürzere Zeit und zwar in folgendem Bereich, nämlich 20 Minuten Dauer bei 200°C bis hin zu 2 Minuten Dauer bei 990 °C.

22. Verfahren zur Herstellung eines in Anspruch 1 beanspruchten Wärmetauschers nach einem der Ansprüche 14 bis 21, **dadurch gekennzeichnet, daß** der Sinterprozeß unter Schutzgas stattfindet.

23. Verfahren zur Herstellung eines in Anspruch 1 beanspruchten Wärmetauschers nach Anspruch 22, **dadurch gekennzeichnet, daß** Wasserstoff als Schutzgas verwendet wird.

24. Verfahren zur Herstellung eines in Anspruch 1 beanspruchten Wärmetauschers nach einem der Ansprüche 14 bis 21, **dadurch gekennzeichnet, daß** der Sinterprozeß unter Abdeckung der Sinterform mit schwefelarmer Holzkohle durchgeführt wird.

## Claims

1. Heat exchanger, which has a cooling body (9) that is in contact with a medium (11) to be cooled, on the one hand, and with a cooling medium (20), on the other hand, and transfers the heat of the medium to be cooled to the cooling medium, the cooling body (9) having sintered parts that form a porous sintered structure through which the cooling medium can flow, **characterized in that** the cooling body is composed of at least two materials, of which one is a better conductor of heat than the other, and the material of better thermal conductivity is essentially in contact with the medium to be cooled and dissipates the heat from the latter to the material of poorer thermal conductivity, which is essentially in contact with the cooling medium, to which for its part it transfers the heat, the material of poorer thermal conductivity serving as support structure for the likewise sintered material of better thermal conductivity, and sintered parts being composed of the material of better thermal conductivity and of the material of poorer thermal conductivity, and the sintering temperature of the material of better thermal conductivity being less than or equal to the sintering temperature of the material of poorer thermal conductivity.

2. Heat exchanger according to Claim 1, **characterized in that** metals are used as the heat-conducting materials, with a metal that is more noble than the material of poorer thermal conductivity being used as the material of better thermal conductivity, and a less noble metal than the material of better thermal conductivity being used as the material of poorer thermal conductivity.

3. Heat exchanger according to Claim 2, **characterized in that** silver is used as the material of better thermal conductivity and copper is used as the material of poorer thermal conductivity.

4. Heat exchanger according to Claim 1, 2 or 3, **characterized in that** the proportion of the material of better thermal conductivity in the cooling body per unit volume of the sintered cooling-body parts decreases with increasing distance from the medium (11) to be cooled.

5. Heat exchanger according to one of Claims 1 to 4, **characterized in that** the cooling body has a shaped structure composed of the material (8) of better conductivity, which distributes the heat into the cooling body (9).

6. Heat exchanger according to Claim 5, **characterized in that** the proportion of material of better conductivity in the cooling body per unit volume of the sintered cooling-body parts decreases with increasing distance from the shaped structure (9) composed of the material of better conductivity.

7. Heat exchanger according to one of Claims 1 to 6, **characterized in that** the cooling body has a passage structure (8, 8a) for guiding the cooling medium, which distributes the cooling medium in the cooling body.

8. Heat exchanger according to Claim 7, **characterized in that** the passage structure has curved passages.

9. Heat exchanger according to Claim 7 or 8, **characterized in that** the passage structure (8) has passages from which, in turn, passages (8a) branch off.

10. Heat exchanger according to one Claims 1 to 9 as a cooling element for cooling an axle (14), **characterized in that** a body (15) composed of the material of better thermal conductivity is essentially in contact with the axle elements to be cooled within the axle to be cooled and dissipates the heat from here to the material of poorer thermal conductivity, which is arranged behind at least one end of the axle and is there essentially in contact with the cooling medium, to which, for its part, it transfers the heat.

11. Heat exchanger according to Claim 10, **characterized in that** the body of material of better thermal conductivity is insulated from the axle elements that are not to be cooled.

12. Heat exchanger according to Claim 10 or 11, **characterized in that** a cooling-body part (9a) that has cooling ribs curved counter to the direction of rotation and rotates with the axle is arranged behind at least one end of the axle.

13. Heat exchanger according to Claim 12, **characterized in that** a Peltier element (16) is mounted between the body (15) of material of better thermal conductivity and the rotating cooling-body part (9a), the cooling side (17) of which is essentially in contact with the body (15) of material of better thermal conductivity and the heat-emitting side (18) of which is essentially in contact with the rotating cooling-body part (9a), thereby improving the dissipation of the heat.

14. Method for producing a heat exchanger claimed in Claim 1, which has the following steps:
(i) a mould (7) is first of all charged with the material of poorer thermal conductivity required for the heat exchanger;
(ii) the mould is then brought to a temperature required to sinter the material of poorer thermal conductivity;
(iii) the mould is then brought to an intermediate cooling temperature;
(iv) changes are then made to the mould, if required;
(v) the mould is then charged with the material of better thermal conductivity required for the heat exchanger;
(vi) the mould is then brought to the temperature required to sinter the material of better thermal conductivity, it being necessary for this temperature to be lower than or equal to the temperature required to sinter the material of poorer thermal conductivity;
(vii) finally the mould is brought to a final cooling temperature.

15. Method for producing a heat exchanger claimed in Claim 1 in accordance with Claim 14, **characterized in that**, after step (i) and before step (ii), the mould (7) is brought to one or more intermediate temperatures in one or more intermediate steps.

16. Method for producing a heat exchanger claimed in Claim 1 in accordance with Claim 14 or 15, **characterized in that**, after step (ii) and before step (iii), the mould (7) is brought to one or more intermediate temperatures in one or more intermediate steps.

17. Method for producing a heat exchanger claimed in Claim 1 in accordance with Claim 14, 15 or 16, **characterized in that**, after step (v) and before step (vi), the mould (7) is brought to one or more intermediate temperatures in one or more intermediate steps.

18. Method for producing a heat exchanger claimed in Claim 1 in accordance with Claim 14, 15, 16 or 17, **characterized in that**, after step (vi) and before step (vii), the mould (7) is brought to one or more intermediate temperatures in one or more intermediate steps.

19. Method for producing a heat exchanger claimed in Claim 1 in accordance with Claim 14, **characterized in that** silver is chosen as the material of better thermal conductivity and copper is chosen as the material of poorer thermal conductivity, and the method has the following steps:
(i) a mould (7) is first of all charged with the copper required for the heat exchanger;
(ii) the mould is then brought to the temperature required to sinter copper, in a range of about 1000°C to 1100°C. preferably 1073°C to 1079°C;
(iii) the mould is then brought to an intermediate cooling temperature of 100°C;
(iv) changes are then made to the mould, if required;
(v) the mould is then charged with the silver required for the heat exchanger;
(vi) the mould is then brought to the temperature required to sinter the silver, in a range of 200°C to 990°C, preferably of about 900°C to 950°C, these temperatures in a range of 200°C to 990°C being lower than or equal to the temperatures in a range of 1000°C to 1100°C required to sinter the less thermally conductive copper;
(vii) finally the mould is brought to a final cooling temperature.

20. Method for producing a heat exchanger claimed in Claim 1 in accordance with Claim 19, **characterized in that** the temperatures in a range of 1073°C to 1079°C in step (ii) are held for about 6 to 12 minutes, and the temperatures in a range of 900°C to 950°C in step (vi) are likewise held for about 6 to 12 minutes.

21. Method for producing a heat exchanger claimed in Claim 1 in accordance with Claim 19, **characterized in that** step (ii) lasts longer at low temperature and for a shorter time at higher temperature, specifically in the following range, namely from 20 minutes at 1000°C to 2 minutes at 1100°C, and step (vi) also lasts longer at low temperature and for a shorter time at higher temperature, specifically in the following range, namely from 20 minutes at 200°C to 2 minutes at 990°C.

22. Method for producing a heat exchanger claimed in Claim 1 in accordance with one of Claims 14 to 21, **characterized in that** the sintering process takes place under a protective gas.

23. Method for producing a heat exchanger claimed in Claim 1 in accordance with Claim 22, **characterized in that** hydrogen is used as the protective gas.

24. Method for producing a heat exchanger claimed in Claim 1 in accordance with one of Claims 14 to 21, **characterized in that** the sintering process is carried out with the sintering mould covered with low-sulphur charcoal.

## Revendications

1. Echangeur de chaleur qui présente un corps de refroidissement (9) qui est en contact d'une part avec un fluide (11) à refroidir et d'autre part avec un fluide de refroidissement (20) et qui transfère au fluide de refroidissement la chaleur du fluide à refroidir, dans lequel
le corps de refroidissement (9) présente des pièces frittées qui forment une structure frittée poreuse qui peut être traversée par le fluide de refroidissement,
**caractérisé en ce que**
le corps de refroidissement est constitué d'au moins deux matériaux dont l'un est meilleur conducteur de chaleur que l'autre, le matériau meilleur conducteur de chaleur étant essentiellement en contact avec le fluide à refroidir et évacuant la chaleur de ce dernier vers le matériau moins bon conducteur de chaleur qui est essentiellement en contact avec le fluide de refroidissement auquel lui-même transfère la chaleur,
le matériau moins bon conducteur de chaleur servant de structure de support pour le matériau meilleur conducteur de chaleur également fritté,
les pièces frittées étant constituées du matériau meilleur conducteur de chaleur et du matériau moins bon conducteur de chaleur et
la température de frittage du matériau meilleur conducteur de chaleur étant inférieure ou égale à la température de frittage du matériau moins bon conducteur de chaleur.

2. Echangeur de chaleur selon la revendication 1, **caractérisé en ce que** comme matériaux conducteurs de chaleur, on utilise des métaux, et comme matériau meilleur conducteur de chaleur, on utilise un métal plus noble que celui du matériau moins bon conducteur de chaleur et comme matériau moins bon conducteur de chaleur un métal moins noble que celui du matériau meilleur conducteur de chaleur.

3. Echangeur de chaleur selon la revendication 2, **caractérisé en ce que** l'on utilise de l'argent comme matériau meilleur conducteur de chaleur et du cuivre comme matériau moins bon conducteur de chaleur.

4. Echangeur de chaleur selon la revendication 1, 2 ou 3, **caractérisé en ce que** sur le corps de refroidissement, la proportion du matériau meilleur conducteur de chaleur par unité de volume des pièces frittées du corps de refroidissement diminue avec l'augmentation de la distance par rapport au fluide (11) à refroidir.

5. Echangeur de chaleur selon l'une des revendications 1 à 4, **caractérisé en ce que** le corps de refroidissement présente une structure façonnée en le matériau (8) meilleur conducteur, laquelle structure répartit la chaleur dans le corps de refroidissement (9).

6. Echangeur de chaleur selon la revendication 5, **caractérisé en ce que** sur le corps de refroidissement, la proportion du matériau meilleur conducteur de chaleur par unité de volume des pièces frittées du corps de refroidissement diminue avec l'augmentation de la distance par rapport à la structure (9) façonnée en le matériau meilleur conducteur.

7. Echangeur de chaleur selon l'une des revendications 1 à 6, **caractérisé en ce que** le corps de refroidissement présente une structure de canaux (8, 8a) pour conduire le fluide de refroidissement et répartir le fluide de refroidissement dans le corps de refroidissement.

8. Echangeur de chaleur selon la revendication 7, **caractérisé en ce que** la structure de canaux présente des canaux courbes.

9. Echangeur de chaleur selon la revendication 7 ou 8, **caractérisé en ce que** la structure de canaux (8) présente des canaux d'où se ramifient d'autres canaux (8a).

10. Echangeur de chaleur selon l'une des revendications 1 à 9, qui sert d'élément de refroidissement pour le refroidissement d'un essieu (14), **caractérisé en ce qu'**un corps (15) en le matériau meilleur conducteur de chaleur et situé à l'intérieur de l'essieu à refroidir est essentiellement en contact avec les éléments de l'essieu à refroidir et évacue leur chaleur vers le matériau moins bon conducteur de chaleur disposé en aval d'au moins une extrémité de l'essieu et qui est en cet endroit essentiellement en contact avec le fluide de refroidissement auquel lui-même transfère la chaleur.

11. Echangeur de chaleur selon la revendication 10, **caractérisé en ce que** le corps en le matériau meilleur conducteur de chaleur est isolé par rapport aux éléments de l'essieu qui ne doivent pas être refroidis.

12. Echangeur de chaleur selon la revendication 10 ou 11, **caractérisé en ce qu'**en aval d'au moins une extrémité de l'essieu est disposée une pièce (9a) du corps de refroidissement qui tourne avec l'essieu et qui présente des nervures de refroidissement repliées dans le sens opposé au sens de rotation.

13. Echangeur de chaleur selon la revendication 12, **caractérisé en ce qu'**entre le corps (15) en le matériau meilleur conducteur de chaleur et la pièce (9a) rotative du corps de refroidissement est installé un élément Peltier (16) dont le côté (17) de refroidissement est essentiellement en contact avec le corps (15) en le matériau meilleur conducteur de chaleur et dont le côté (18) d'évacuation de chaleur est essentiellement en contact avec la pièce (9a) rotative du corps de refroidissement, de manière à améliorer ainsi l'évacuation de la chaleur.

14. Procédé de fabrication d'un échangeur de chaleur revendiqué dans la revendication 1, et qui présente les étapes suivantes :
(i) tout d'abord, on remplit un moule (7) avec le matériau moins bon conducteur de chaleur nécessaire pour l'échangeur de chaleur,
(ii) le moule est ensuite amené à une température nécessaire pour le frittage du matériau moins bon conducteur de chaleur,
(iii) le moule est alors amené à une température intermédiaire de refroidissement,
(iv) éventuellement, des modifications sont effectuées alors sur le moule,
(v) on remplit ensuite le moule avec le matériau meilleur conducteur de chaleur nécessaire pour l'échangeur de chaleur,
(vi) le moule est ensuite amené à une température nécessaire pour le frittage du matériau meilleur conducteur de chaleur, celle-ci devant être inférieure ou égale à la température nécessaire pour le frittage du matériau moins bon conducteur de chaleur,
(vii) enfin, le moule est amené à une température de refroidissement final.

15. Procédé de fabrication d'un échangeur de chaleur revendiqué dans la revendication 1, selon la revendication 14, **caractérisé en ce que** après l'étape (i) et avant l'étape (ii), le moule (7) est amené en une ou plusieurs étapes intermédiaires à une ou plusieurs températures intermédiaires.

16. Procédé de fabrication d'un échangeur de chaleur revendiqué dans la revendication 1, selon la revendication 14 ou 15, **caractérisé en ce qu'**après l'étape (ii) et avant l'étape (iii), le moule (7) est amené en une ou plusieurs étapes intermédiaires à une ou plusieurs températures intermédiaires.

17. Procédé de fabrication d'un échangeur de chaleur revendiqué dans la revendication 1, selon la revendication 14, 15 ou 16, **caractérisé en ce qu'**après l'étape (v) et avant l'étape (vi), le moule (7) est amené en une ou plusieurs étapes intermédiaires à une ou plusieurs températures intermédiaires.

18. Procédé de fabrication d'un échangeur de chaleur revendiqué dans la revendication 1, selon la revendication 14, 15, 16 ou 17, **caractérisé en ce qu'**après l'étape (vi) et avant l'étape (vii), le moule (7) est amené en une ou plusieurs étapes intermédiaires à une ou plusieurs températures intermédiaires.

19. Procédé de fabrication d'un échangeur de chaleur revendiqué dans la revendication 1, selon la revendication 14, **caractérisé en ce que** l'on sélectionne l'argent comme matériau meilleur conducteur de chaleur et le cuivre comme matériau moins bon conducteur de chaleur, le procédé comprenant les étapes suivantes :
(i) tout d'abord on remplit un moule (7) avec le cuivre nécessaire pour l'échangeur de chaleur,
(ii) le moule est ensuite amené à la température nécessaire pour le frittage du cuivre, située dans la plage d'environ 1 000°C à 1 100°C et de préférence de 1 073°C à 1 079°C,
(iii) le moule est ensuite amené à une température intermédiaire de refroidissement de 100°C,
(iv) éventuellement, des modifications sont alors effectuées sur le moule,
(v) on remplit ensuite le moule avec l'argent nécessaire pour l'échangeur de chaleur,
(vi) le moule est ensuite amené à la température nécessaire pour le frittage de l'argent, située dans la plage de 200°C à 990°C, de préférence d'environ 900°C à 950°C, ces températures comprises dans la plage de 200°C à 990°C étant inférieures ou égales aux températures nécessaires au frittage du cuivre moins bon conducteur de chaleur et situées dans la plage de 1 000°C à 1 100°C,
(vii) enfin, le moule est amené à une température de refroidissement final.

20. Procédé de fabrication d'un échangeur de chaleur revendiqué dans la revendication 1, selon la revendication 19, **caractérisé en ce que** les températures comprises dans la plage de 1 073°C à 1 079°C dans l'étape (ii) sont maintenues pendant environ 6 à 12 minutes, et les températures comprises dans la plage de 900°C à 950°C de l'étape (vi) sont également maintenues pendant environ 6 à 12 minutes.

21. Procédé de fabrication d'un échangeur de chaleur revendiqué dans la revendication 1, selon la revendication 19, **caractérisé en ce que** l'étape (ii) s'étend sur une durée plus longue à basse température et une durée plus courte à haute température, et ce dans la plage suivante, à savoir d'une durée de 20 minutes à 1 000°C jusqu'à une durée de 2 minutes à 1 100°C, et l'étape (vi) s'étend également pendant une durée plus longue à basse température et une durée plus courte à haute température et ce dans la plage suivante, à savoir d'une durée de 20 minutes à 200°C jusqu'à une durée de 2 minutes à 990°C.

22. Procédé de fabrication d'un échangeur de chaleur revendiqué dans la revendication 1, selon l'une des revendications 14 à 21, **caractérisé en ce que** l'opération de frittage a lieu sous gaz protecteur.

23. Procédé de fabrication d'un échangeur de chaleur revendiqué dans la revendication 1, selon la revendication 22, **caractérisé en ce que** l'on utilise de l'hydrogène comme gaz protecteur.

24. Procédé de fabrication d'un échangeur de chaleur revendiqué dans la revendication 1, selon l'une des revendications 14 à 21, **caractérisé en ce que** l'opération de frittage est réalisée avec recouvrement du moule de frittage par du charbon de bois pauvre en soufre.
